# EUROPEAN PATENT SPECIFICATION

(11) **EP 1 312 248 B1**
(45) Date of publication and mention of the grant of the patent: **12.05.2004**
(21) Application number: 01958274.1
(22) Date of filing: 22.08.2001
(51) Int. Cl.: H05K 7/20, H02M 7/00, H01L 23/467

(54) **A COOLING SYSTEM**
KÜHLSYSTEM
SYSTEME DE REFROIDISSEMENT

(30) Priority: 22.08.2000 ZA 200104309
(43) Date of publication of application: 21.05.2003
(73) Proprietor: Metalspray International LC, 2093 Industria (ZA)
(72) Inventor: SEITZ, Michael Walter, 1724 Roodepoort (ZA)
(74) Representative: Pluckrose, Anthony William
(86) International application number: PCT/IB2001/001516
(87) International publication number: WO 2002/016851

(56) References cited:
- DE-A- 2 122 887
- DE-A- 3 138 521
- DE-A- 4 021 683
- US-A- 3 400 543
- US-A- 5 823 005
- US-A- 6 108 206

## Description

### BACKGROUND OF THE INVENTION

This invention relates to a cooling system, particularly for apparatus which uses compressed or induced air flow during its normal operation, see for example DE-A-3 138 521.

Typically, apparatus which has parts needing to be cooled, such as the power supply of the apparatus, uses a fan to blow air onto the power supply to cool the power supply, particularly the diodes or thyristors of the power supply. However, in order for the fan to work, it requires an inlet and an outlet, which in effect means that dirt and dust can get into the apparatus. The dirt and dust can cause the fan to seize and the system to consequently overheat.

The present invention therefore provides an improved cooling system.

### SUMMARY OF THE INVENTION

According to the present invention there is provided a cooling system for apparatus, which apparatus uses compressed air or induced air flow during its normal operation, the cooling system comprising:
at least one heat exchange member in thermal connection with a part of the apparatus to be cooled, the at least one heat exchange member having a passage therein through which air can travel; and
an auxiliary air guide for diverting the air through the passage in the at least one heat exchange member before diverting the air back to the existing piping or tubing of the apparatus, so that the air can subsequently be used for the normal operation of the apparatus.

Preferably, a plurality of heat exchange members are in thermal connection with a plurality of parts of the apparatus to be cooled.

The auxiliary air guide may further divert the air from one heat exchange member to the next before diverting the air back to the existing piping or tubing of the apparatus.

The parts of the apparatus to be cooled may be diodes or thyristors which form part of a diode rectification bridge.

The apparatus may be an arc spraying device.

Preferably, the auxiliary air guide is made from a material which is not electrically conductive.

### BRIEF DESCRIPTION OF THE DRAWINGS

- **Figure 1**: is a perspective view of a part of the cooling system of the present invention;
- **Figure 2**: illustrates one of the heat exchange members of the cooling system illustrated in Figure 1;
- **Figure 3**: is a schematic illustration of the electrical circuit of the system of Figure 1; and
- **Figure 4**: is a schematic illustration of the system of Figure 1.

### DESCRIPTION OF AN EMBODIMENT

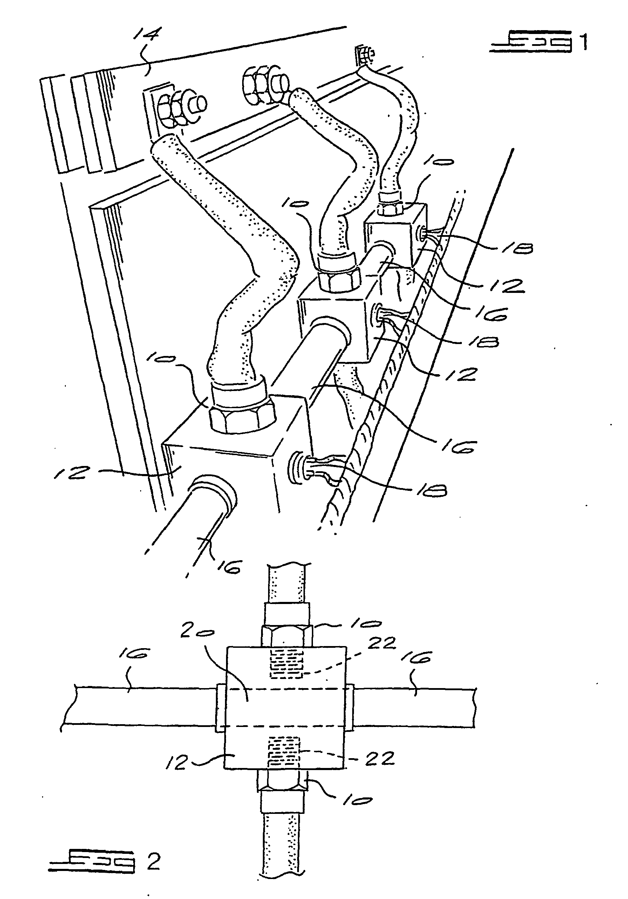

Referring to Figure 1, the prototype of the present invention was implemented to cool the power supply for an arc spray apparatus.

However, it will be appreciated that the present invention could equally be used to cool part of any apparatus which uses a compressed or induced air flow during its normal operation.

The power supply of the apparatus to which the prototype cooling system of the present invention is applied is a 21 kVA three phase transformer system for powering an arc spray gun.

In order to produce an output of 50 volts at 300 amps for the arc, a six diode full wave rectification bridge is used. Alternatively, a variable voltage thyristor system may be used in place of the diodes.

It will be appreciated that in such a setup, the diodes or thyristors would get very hot if they were not cooled (typically greater than 200°C).

Each diode 10 is in thermal connection with a heat exchange member in the form of an aluminium block 12. It will be appreciated that any other good conducting metal could be used, for example, copper.

The diodes 10 are connected to aluminium blocks 12 by means of a screw threaded stud 22.

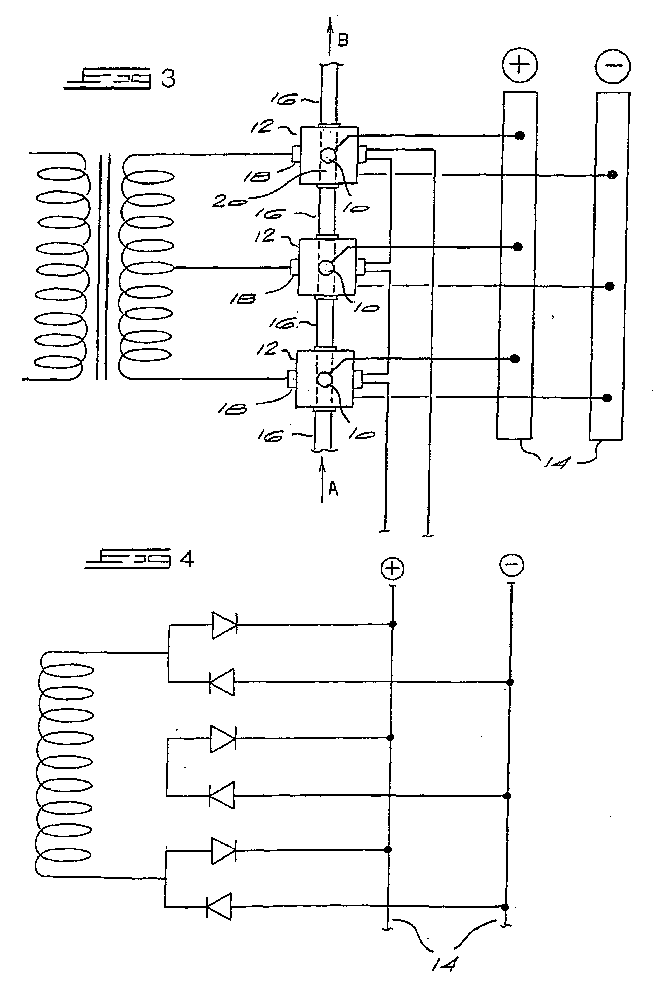

As can be more clearly seen in Figure 3, each pair of diodes 10 are connected to one of the three phases of the transformer and each one of the diodes 10 is connected to either the positive or the negative bar of an output DC bus system 14.

Each of the aluminium blocks 12 has a passage 20 therein through which air can travel via an auxiliary air guide in the form of pipes 16. The passage 20 in the aluminium blocks 12 allows compressed or induced air to flow from one pipe 16 to another pipe 16.

Referring to Figure 3, compressed or induced air enters the first pipe 16 of the cooling system and flows in the direction of arrow A through the first aluminium block 12. The air flows through the passage 20 in the aluminium block 12 and into the second pipe 16, before flowing into the second aluminium block 12. After flowing through the last pipes 16 and aluminium block 12, the air flows back to the existing air flow passage of the apparatus, in the direction of arrow B.

Because each of the pairs of diodes 10 are connected to a different phase of the transformer, the pipes 16 must be made from a material which is not electrically conductive.

Thermal switches 18 are connected to each of the aluminium blocks 12 and are set to switch the apparatus off if they sense a pre-determined temperature.

In the prototype apparatus, the thermal switches are set to switch the apparatus off at 100°C.

In use, the compressed or induced air which is normally used to spray finely atomised particles out of the nozzle of the apparatus is first diverted from the compressed or induced air source (not shown) through the pipes 16 and aluminium blocks 12. This air flow effectively cools the aluminium blocks 12 and prevents the diodes 10 from overheating.

In a test on the prototype apparatus conducted in an ambient air temperature of 25°C, and when the apparatus was fully functional, the diodes only reached a temperature of about 40°C.

Because no inlet or outlet is needed for a cooling fan, the case containing the apparatus and the cooling system of the present invention can be sealed in an air-tight manner. This is obviously very advantageous especially if the apparatus is used in a typically dirty environment, such as is the case with an arc spray apparatus.

Furthermore, although the complete auxiliary air path should ideally not have any air leaks, if there were a small leak along this auxiliary path, the case of the apparatus would become positively pressurised and would further inhibit entry of dust or other particles. This is therefore not entirely undesirable.

In any event, since a fan is not used which requires an inlet and an outlet, dust and other particles are prevented from entering the case of the apparatus. In addition, the prototype of the cooling system has been shown to effectively cool the diodes more effectively than prior art fan systems.

## Claims

1. A cooling system for apparatus, which apparatus uses compressed or induced air flow during its normal operation, the cooling system comprising:
at least one heat exchange member (12) in thermal connection with a part (10) of the apparatus to be cooled, the at least one heat exchange member having a passage (20) therein through which air can travel; and
an auxiliary air guide (16) for diverting the air through the passage in the at least one heat exchange member (10) before diverting the air back to the existing piping or tubing of the apparatus, so that the air can subsequently be used for the normal operation of the apparatus.

2. A cooling system according to claim 1 wherein a plurality of heat exchange members are in thermal connection with a plurality of parts of the apparatus to be cooled.

3. A cooling system according to claim 2 wherein the auxiliary air guide diverts the air from one heat exchange member to the next before diverting the air back to the existing piping or tubing of the apparatus.

4. A cooling system according any preceding claim wherein the parts of the apparatus to be cooled are diodes or thyristors which form part of a diode rectification bridge.

5. A cooling system according to any preceding claim wherein the apparatus is an arc spraying device.

6. A cooling system according to any preceding claim wherein the auxiliary air guide is made from a material which is not electrically conductive.

## Patentansprüche

1. Kühlsystem für eine Vorrichtung, die während des normalen Betriebes einen Strom komprimierter oder angesaugter Luft verwendet, das Kühlsystem weist auf:
zumindest ein Wärmetauscherteil (12), das in thermischer Verbindung mit einem zu kühlenden Teil (10) der Vorrichtung steht, das zumindest eine Wärmetauscherteil weist einen Durchgang (20) darin auf, durch welchen Luft durchströmen kann; und
eine Zusatzluftführung (16) zum Ableiten der Luft durch den Durchgang in dem zumindest einen Wärmetauscherteil (10), bevor die Luft zurück zu der vorhandenen Leitung oder Rohrleitung der Vorrichtung abgeleitet wird, so dass die Luft nachfolgend für den normalen Betrieb der Vorrichtung verwendet werden kann.

2. Kühlsystem nach Anspruch 1, wobei eine Vielzahl von Wärmetauscherteilen in thermischer Verbindung mit einer Vielzahl von zu kühlenden Teilen der Vorrichtung stehen.

3. Kühlsystem nach Anspruch 2, wobei die Zusatzluftführung die Luft von einem Wärmetauscherteil zu dem nächsten ableitet, bevor die Luft zurück zu der bestehenden Rohrleitung oder dem Röhrenwerk der Vorrichtung abgeleitet wird.

4. Kühlsystem nach einem der voranstehenden Ansprüche, wobei die zu kühlenden Teile der Vorrichtungen Dioden oder Thyristoren sind, die einen Teil einer Diodengleichrichterbrücke sind.

5. Kühlsystem nach einem der voranstehenden Ansprüche, wobei die Vorrichtung eine Lichtbogenschmelzvorrichtung ist.

6. Kühlsystem nach einem der voranstehenden Ansprüche, wobei die Zusatzluftführung aus einem elektrisch nicht leitenden Material hergestellt ist.

## Revendications

1. Système de refroidissement pour un appareil, lequel appareil utilise pendant son fonctionnement normal un courant d'air comprimé ou forcé, le système de refroidissement comprenant :
au moins un élément d'échange de chaleur (12) en relation thermique avec une partie (10) de l'appareil à refroidir, ledit au moins un élément d'échange de chaleur contenant un passage (20) par lequel de l'air peut circuler ; et
un guide d'air auxiliaire (16) servant à diriger l'air pour qu'il s'écoule dans le passage dudit au moins un élément d'échange de chaleur (10) avant de faire revenir l'air jusqu'au tuyau ou tube existant de l'appareil, afin que l'air puisse être ensuite utilisé pour le fonctionnement normal de l'appareil.

2. Système de refroidissement selon la revendication 1, dans lequel une pluralité d'éléments d'échange de chaleur sont en relation thermique avec une pluralité de parties de l'appareil à refroidir.

3. Système de refroidissement selon la revendication 2, dans lequel le guide d'air auxiliaire dirige l'air d'un élément d'échange de chaleur au suivant avant de faire revenir l'air dans le tuyau ou le tube existant de l'appareil.

4. Système de refroidissement selon l'une quelconque des revendications précédentes, dans lequel les parties de l'appareil à refroidir sont des diodes ou des thyristors qui font partie d'un pont de diodes de redressement.

5. Système de refroidissement selon l'une quelconque des revendications précédentes, dans lequel l'appareil est un dispositif de pulvérisation à arc.

6. Système de refroidissement selon l'une quelconque des revendications précédentes, dans lequel le guide d'air auxiliaire est en matériau électriquement non conducteur.
